# EUROPEAN PATENT SPECIFICATION

(11) **EP 1 255 278 B1**
(45) Date of publication and mention of the grant of the patent: **15.06.2005**
(21) Application number: 01109943.9
(22) Date of filing: 24.04.2001
(51) Int. Cl.: H01J 37/29

(54) **Scanning particle mirror microscope**
Teilchenstrahl-Raster-Spiegelmikroskop
Microscope a mirroir à particules à balayage

(43) Date of publication of application: 06.11.2002
(73) Proprietor: Advantest Corporation, Tokyo 163-08 (JP)
(72) Inventor: Frosien, Jürgen, Dr., 85521 Riemerling (DE)
(74) Representative: Tetzner, Thomas

(56) References cited:
- US-A- 3 714 425
- WITZANI ET AL: "Scanning Electron Mirror Microscopy" SCANNING, vol. 4, no. 2, 1981, pages 53-61, XP001018197

## Description

The invention relates to a scanning particle mirror microscope.

During the inspection of large-area and planar substrates from the semiconductor industry, such as masks and wafers, use is made for example of high-resolution scanning electron microscopes. These devices have a source for generating a primary particle beam, at least one lens arrangement for focussing the primary particle beam onto the specimen, a scan deflection system in order to deflect primary the particle beam over the specimen, and a detector for detecting the particles coming from the specimen.

The scanning electron microscopes are preferably operated in the low-voltage range around 1 keV primary electron energy in order to avoid or minimise damage and charging due to the primary beam.

Although these devices are widely used, they have some disadvantages. Thus, in spite of the low primary electron energy, charges still occur on the surface of the specimen which restrict and accordingly falsify the imaging. Moreover, damage to the specimen cannot be completely excluded and contaminations of the surface of the specimen occur due to the deposition of carbon from the residual gas atmosphere, soiling the specimen and altering the surface and therefore the imaging thereof.

A further known method for imaging of the surfaces of specimens is known from surface analysis technology. In this discipline so-called mirror microscopy is used in order to generate images of the surface by using the reflected particles. With this technique the surface of the specimen is illuminated over a large area with a parallel electron bundle so that the specimen is at a retarding voltage which is somewhat higher than the beam voltage of the primary electron beam. The effect of this retarding voltage is that the primary electron beam can no longer strike the specimen but is reflected shortly before the specimen. If the specimen is a planar surface, then the parallel bundle of the primary electron beam is reflected into itself completely undisturbed and returns into the optical system. When a beam splitter is used, the reflected bundle can be separated from the primary electron beam bundle and evaluated in a suitable optical imaging system.

In the case of a non-planar specimen, i.e. a specimen with surface topography, the illuminating primary electron beam is no longer reflected back into itself. At the points on the surface where there are inclinations the reflecting potential surfaces are also constructed with corresponding inclinations, so that the perpenticular beam is reflected at an angle which depends upon the local inclination of the specimen. If the imaging system connected has a contrast diaphragm which only allows the electrons reflected into themselves to pass but separates out those reflected with an inclination, then an image of the surface of the specimen can be generated without the specimen having to come into contact with particles. This principle of mirror microscopy does have the advantage that damage, charging and contamination of the specimen can be completely avoided; on the other hand, however, with this technique mainly topographical structures on a planar substrate can be made visible, since such structures "distort" the reflector surface in a suitable manner and accordingly generate contrasts. The essential disadvantages of the reflector microscopes are their complex construction and their costly operation. Mirror microscopes require a complete microscope for large-area and parallel illumination of the surface of the specimen, a beam splitter for separating the illuminating beam path from the imaging beam path, a complete microscope for enlarged imaging of the surface of the specimen and a parallel-imaging detector for recording the surface image.

The successful development of scanning electron microscopy with all its facilities of small area analysis and signal processing gave a new impetus to mirror microscopy. The advantages of both techniques, of the scanning and the mirror method, have been combined in a new research tool, the scanning electron mirror microscope. The article of J. Witzani, E.M. Horl "Scanning Eletrcon Mirror Microscopy" in Scanning, Vol.4, pages 53 - 61 (1981) gives a review of the working principles, instrument designs and application of scanning electron mirror microscopy.

Furthermore, US-A-3 714 425 discloses a reflecting mirror type electron microscope.

The object of the invention, is to provide a scanning particle mirror microscope which generates improved images of the specimen.

This object is achieved by the features of claim 1.

Further embodiments of the invention are the subject matter of the subordinate claims.

The scanning particle mirror microscope according to the invention consists essentially of a source for generating a primary particle beam, at least one lens arrangement for focussing the primary particle beam, a scan deflection system in order to deflect the primary particle beam over the specimen, a detector for detecting particles, and means for generating a retarding field just above the specimen, wherein the retarding field is adapted in that at least a part of the primary particle beam is reflected before it reaches the specimen and at least some of the reflected particles reach the detector. Furthermore, the scan deflection system is disposed in the front focal plate of the lens arrangement.

The scanning mirror microscope according to the invention generates a primary particle beam which is scanned parallel over the specimen. Therefore, every point on the specimen is treated equally.

In one embodiment of the invention, the lens arrangement is defined by an immersion lens, preferably by a combined electrostatic-magnetic immersion lens. Such an arrangement allows short working distances.

In an advantageous embodiment of the invention a contrast diaphragm is provided for selecting out a proportion of the reflected particles. In this case the proportion of the particles which is selected out can be formed by the particles reflected obliquely with respect to the surface of the specimen or by particles reflected perpendicular to the surface of the specimen.

It is also provided that the scan deflection system is preferably constructed as an electrostatic deflector system.

In one embodiment of the invention, the means for generating a retarding field above the specimen are provided by means for supplying a retarding voltage to at least a part of the specimen.

Further advantages and embodiments of the invention are explained in greater detail with reference to the following description of some examples of construction and to the drawings, in which:
Figure 1 shows a basic representation of the scanning particle mirror microscope according to the invention,
Figure 2 shows a diagrammatic representation of the scanning particle mirror microscope according to a first variant,
Figure 3 shows a diagrammatic representation of a scan deflection system,
Figure 4 shows a diagrammatic representation of the scanning particle mirror microscope according to a second variant,
Figure 5 shows a diagrammatic representation of the scanning particle mirror microscope according to a third variant,
Figure 6 shows a diagrammatic representation of the scanning particle mirror microscope according to a fourth variant,
Figure 7 shows a diagrammatic representation of the scanning particle mirror microscope according to a fifth variant,
Figure 8 shows a representation of a reflected primary particle beam in the region of the specimen,
Figure 9 shows a representation of a partly reflected beam in the region of the specimen.

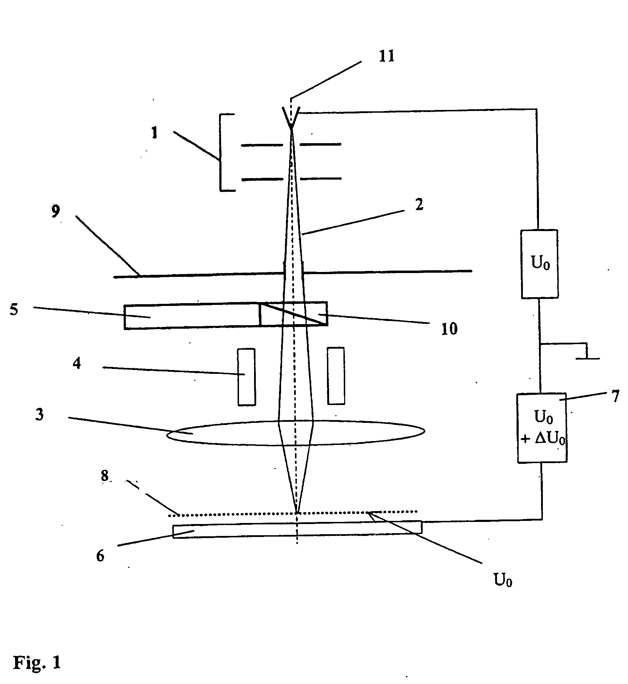

Figure 1 shows the basic construction of the scanning particle mirror microscope. It consists essentially of a source 1 for generating a primary particle beam 2, at least one lens arrangement 3 for focussing the primary particle beam, a scan deflection system 4 and a detector 5 for detecting particles.

The specimen to be examined is denoted by the reference numeral 6. Means 7 are also provided for supplying at least a part of the specimen with a retarding voltage U₀ + ΔU₀, the absolute value of the retarding voltage being higher than the absolute value of the voltage U₀ of the primary particle beam 2, so that the primary particle beam is reflected before it reaches this part of the specimen and at least a proportion of the reflected particles reaches the detector 5.

In electron beam systems a field emission source or thermal emission source is used as the source 1. The lens arrangement 3 serves to reduce the size of the source and to focus the primary particle beam into the vicinity of the surface of the specimen. The means 7 are usually formed by a voltage supply arrangement. Further components, such as alignment deflectors, stigmators, etc., are not shown in greater detail for reasons of clarity. Moreover, within the scope of the invention further lenses are possible for reducing the size of the source or for carrying out other functions.

The lens arrangement 3 can for example be formed by a magnetic lens (conventional magnetic lens or single pole piece lens disposed in front of or behind the specimen), an electrostatic lens or a combined magnetic-electrostatic lens. A fundamental component of the lens arrangement 3 is a decelerating retarding field which is built up in front of the specimen so that the primary particle beam 2 is reflected shortly before it reaches the surface of the specimen. The reflector plane 8 is represented in the drawing by a dotted line.

An aperture 9 for limiting the aperture angle of the primary particle beam is also provided in the beam path of the particle beam 2.

Figure 1 shows the conditions in the case of a planar surface of the specimen so that the primary particle beam 2 is reflected back into itself on the reflector plane 8. For detection of the reflected particles a beam splitter 10 may be used for example, which allows the primary particle beam 2 to pass but deflects the reflected particles and delivers them to the detector 5.

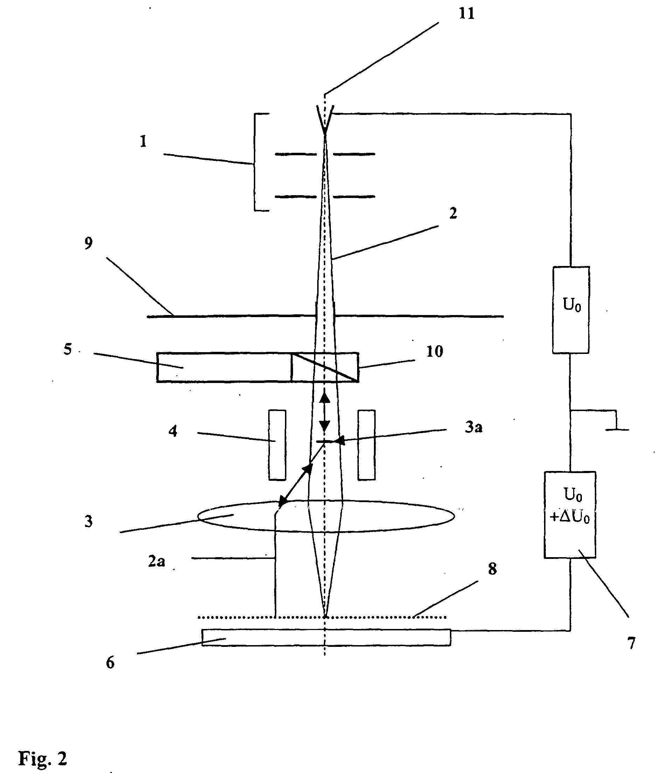

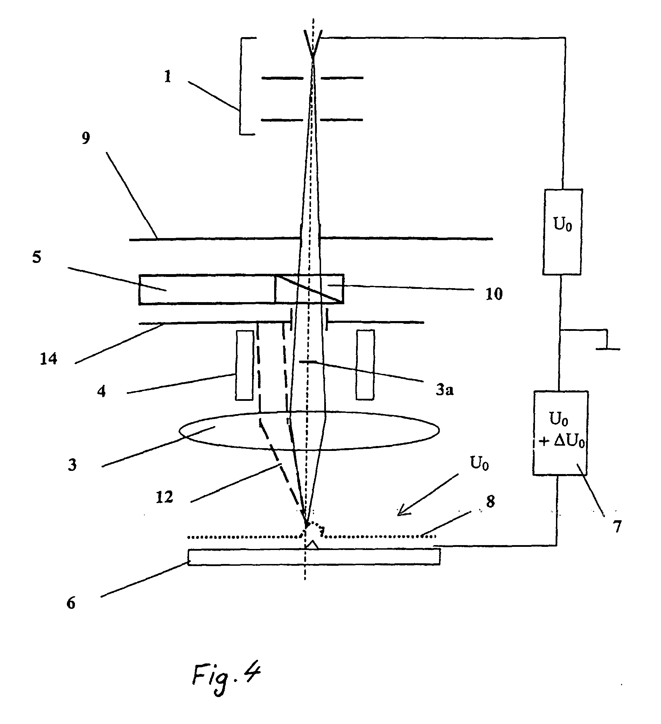

The purpose of the scan deflection system 4 is to deflect the primary particle beam 2 over the specimen 6, as indicated diagrammatically in Figure 2.

The same reference numerals are used for corresponding components in the representation according to Figure 2 and also all further representations.

In order to ensure that all points on the specimen are processed in the same way, during scanning the primary particle beam is aligned in all points perpendicular to the specimen. This is achieved by disposing the scan deflection system 4 really or virtually in the front focal plane 3a of the lens arrangement (Figure 2) i.e. in the real front focal plane of the lens arrangement. In Figure 2 the deflected primary particle beam 2 is denoted by 2a and it is aligned perpendicular to the specimen 6, i.e. it strikes the specimen 6 perpendicularly. The reflected particles again run coincident with the primary particle beam as far as the beam splitter 10, where they are deflected to the detector.

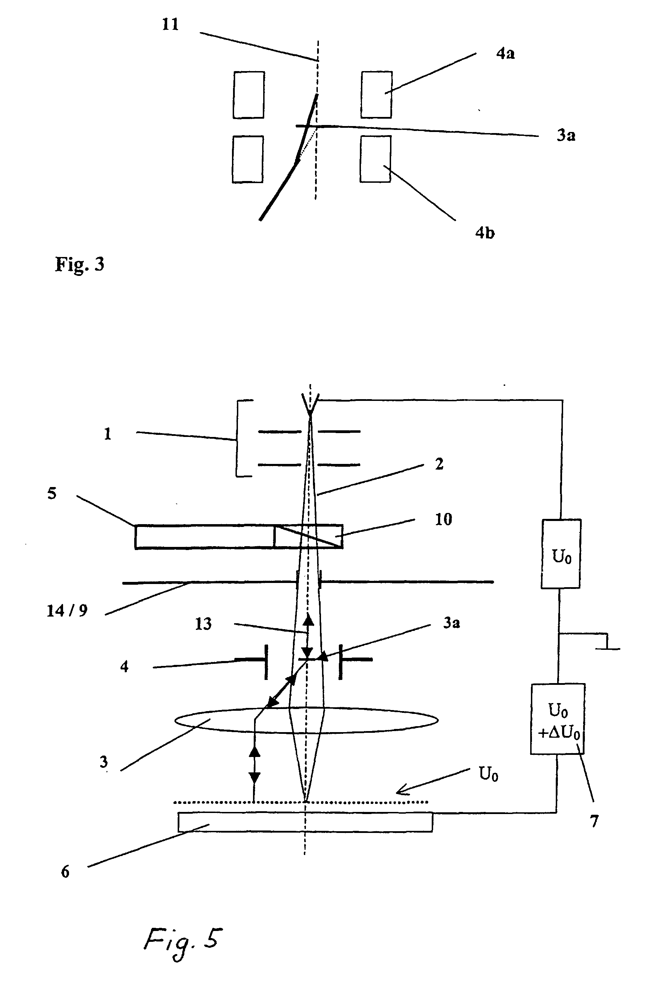

Since in this case it is a question very precisely of exact positioning of the scan deflection system 4 (in the direction of the optical axis 11) in the front focal plane 3a of the lens arrangement 3, it is advantageous also in the case of a single-stage deflector system to divide the deflector into two partial deflectors 4a, 4b, of which one is disposed in front of the front focal plane 3 and the other behind it (see Fig.3). In this way it is possible by appropriate control of the two partial deflectors to achieve an exact balance of the resulting scan deflection system in the front focal plane 3a.

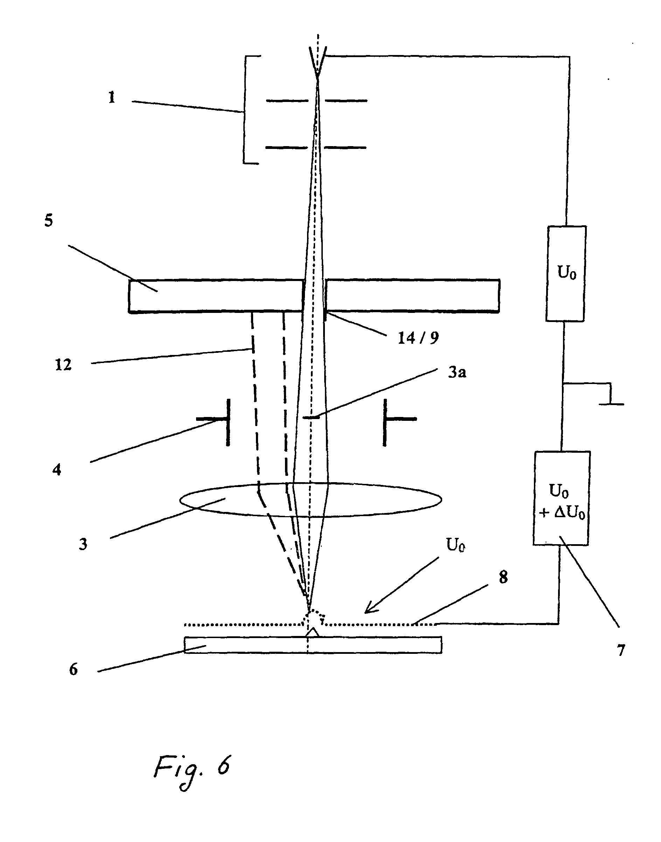

In the case of the reflected particles there is a basic distinction to be made between two types, namely the particles reflected perpendicular to the surface of the specimen and the particles reflected obliquely with respect to the surface of the specimen. In the case of a specimen surface which is planar, i.e. a specimen surface which is aligned perpendicular to the optical axis 11 of the scanning particle mirror microscope, the reflected particles are reflected perpendicular to the surface of the specimen. In the case of a specimen surface which has inclined parts, as indicated in Figure 4, particles 12 are produced which are reflected obliquely with respect to the surface of the specimen. If the particles reflected perpendicularly or the particles reflected obliquely with respect to the surface of the specimen are passed to the detector, data can be obtained concerning the surface configuration of the specimen.

In order to select out the particles which are reflected obliquely with respect to the surface of the specimen, in the variants according to Figures 4 and 5 a contrast diaphragm 14 is provided which selects out all the particles which are reflected obliquely with respect to the surface of the specimen and only allows the particles 13 reflected perpendicular to the surface of the specimen to pass and thus to reach the detector 5.

In the variant according to Figure 5, the detector is disposed in front of the aperture diaphragm in the direction of the primary particle beam 2, and in this case the aperture diaphragm and the contrast diaphragm are formed by one and the same diaphragm. In the embodiment according to Figure 4, on the other hand, the detector 5 is disposed between the aperture diaphragm 9 and the contrast diaphragm 14.

The possibility also exists of dispensing with a beam splitter by constructing the contrast diaphragm 14 itself as the detector 5, as shown in Figure 6. In this variant, in contrast to the previous embodiments, it is not the particles reflected perpendicular to the surface of the specimen which are detected, but the particles 13 reflected obliquely with respect to the surface of the specimen.

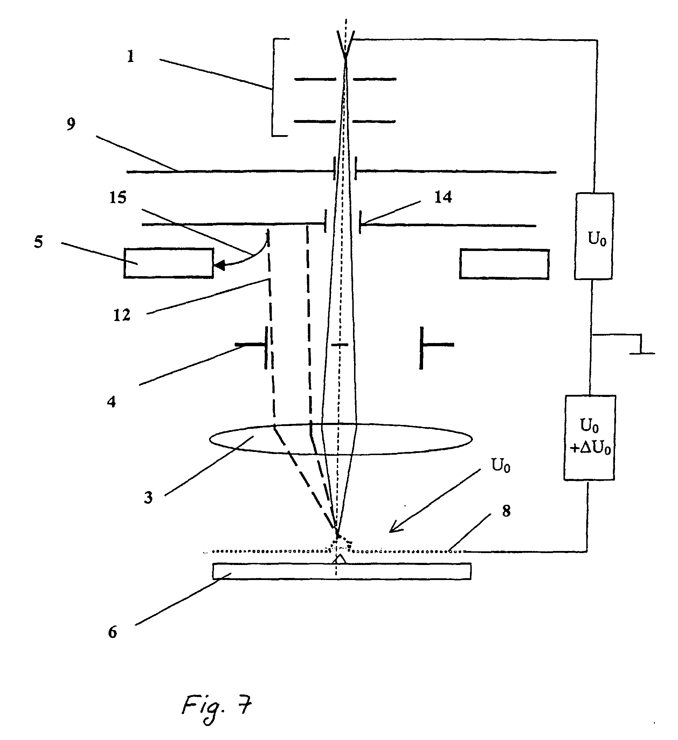

The variant according to Figure 7 also functions according to this principle, and in this variant the contrast diaphragm 14 serves as converter electrode and the secondary particles (arrow 15), which are released on the converter electrode by the particles 12 reflected obliquely with respect to the surface of the specimen, reach the detector 5.

In all the variants the use of electrostatic scan deflection systems is particularly advantageous, since in this case a beam is deflected independently of the direction of travel of the particles, so that for all points on the specimen (in the case of perpendicular incidence and planar reflector surface) the primary particle beam and the reflected particles are coincident not only in front of the raster deflector system but also behind it, and this applies for all angles of deflection. Thus axial beams and off-axial beams have practically no difference.

Furthermore, it is conceivable within the scope of the..invention that only a part of the specimen is supplied with a sufficient retarding voltage in order to reflect the primary particle beam 2 before it reaches the specimen. If another part of the specimen is supplied with an insufficient retarding voltage, then the primary particle beam 2 can release secondary particles there on the specimen and these can be detected by the detector (SE mode). The method according to the invention can then provide as required a reflector mode, a SE mode or a mixed operation between reflector mode and SE mode.

The supply of an insufficient retarding voltage to certain parts of the specimen can be achieved in particular by first of all irradiating the specimen so that a part of the specimen is charged, so that the retarding voltage subsequently applied to the entire specimen is not sufficient in this previously charged part of the specimen, so that the primary particle beam there reaches as far as the specimen and releases secondary particles there. It is also possible to charge parts of the specimen by means of UV light, electrons or other particles.

By this mixed operation not only reflected particles but also particles released on the specimen reach the detector. By this mixed operation additional data, e.g. material, conductivity, can be obtained in certain circumstances concerning the surface configuration of the specimen.

Another mixed operation is possible if the retarding field is adapted in that one part of the primary particle beam is reflected before it reaches the specimen and the other part reaches the specimen in order to release secondary electrons on the specimen. This mode is based on the fact that the focussed primary particle beam has an aperture angle. Consequently, the particles of the primary particle beam being close to the optical axis 11 have a higher energy perpendicular to the surface of the specimen than those particles having a greater distance from the optical axis.

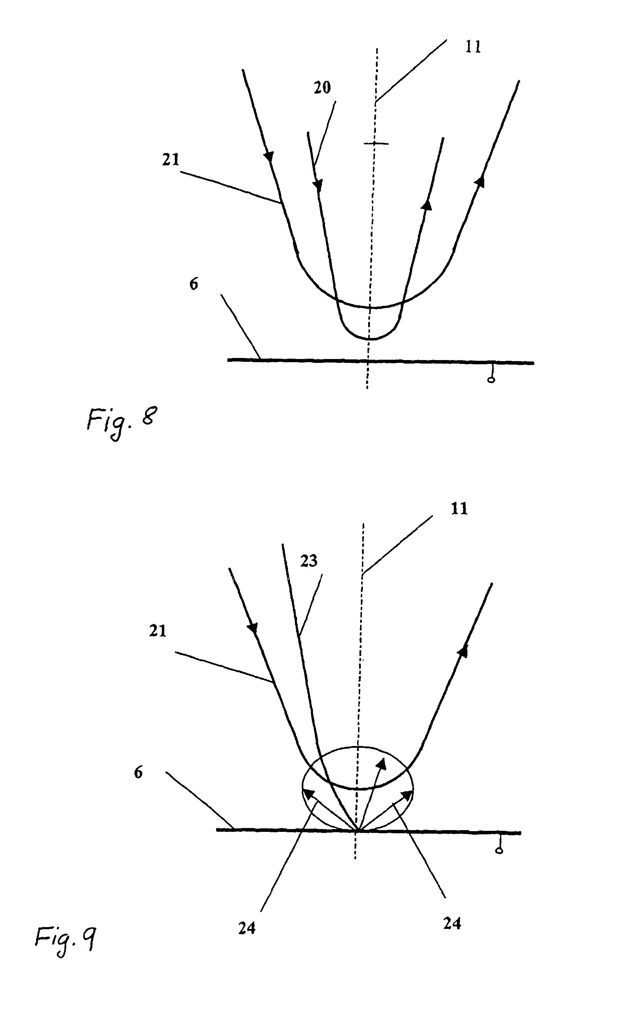

Fig. 8 discloses a primary particle beam having primary particles 21 which have a greater distance from the optical axis 11 and a larger tilt angle. Consequently they are reflected well before the specimen 6. Those particles 20 being close to the optical axis 11 have a higher axial energy and therefore will get closer to the specimen before they will be reflected.

Consequently, it is possible to adapt the retarding field above the specimen 6 in that the particles 21 having a greater distance from the optical axis 11 are reflected before they reach the specimen while the primary particles 23 being closer to the optical axis reach the specimen and will release secondary electrons 24 (see Fig. 9).

## Claims

1. Scanning particle mirror microscope with
- a source (1) for generating a primary particle beam (2),
- at least one lens arrangement (3) for focussing the primary particle beam,
- a scan deflection system (4) in order to deflect the primary particle beam over the specimen,
- a detector (5) for detecting particles,
- and means (7) for generating a retarding field just above the specimen wherein the retarding field is adapted in that at least a part of the primary particle beam is reflected before it reaches the specimen, and at least some of the reflected particles reach the detector,
**characterised in that**
the scan deflection system (4) is disposed in the front focal plane (3a) of the lens arrangement (3).

2. Scanning particle mirror microscope as claimed in Claim 1, **characterised in that** the lens arrangement is defined by an immersion lens.

3. Scanning particle mirror microscope as claimed in Claim 1, **characterised in that** the lens arrangement is defined by a combined electrostatic-magnetic immersion lens.

4. Scanning particle mirror microscope as claimed in Claim 1, **characterised in that** the scan deflection system (4) is constructed as an electrostatic deflector system.

5. Scanning particle mirror microscope as claimed in Claim 1, **characterised in that** the detector is arranged - in the direction of the primary particle beam - in or in front of the lens arrangement (3).

6. Scanning particle mirror microscope as claimed in Claim 1, **characterised in that** the means for generating a retarding field above the specimen are provided by the means for supplying a retarding voltage to at least a part of the specimen.

7. Scanning particle mirror microscope as claimed in Claim 6, **characterised in that** the absolute value of the retarding voltage is higher than the absolute value of the voltage of the primary particle beam.

8. Scanning particle mirror microscope as claimed in Claim 1, **characterised by** a contrast diaphragm (14) for selecting out a proportion of the reflected particles.

9. Scanning particle mirror microscope as claimed in Claim 1, **characterised by** a contrast diaphragm (14) for selecting out a proportion of the particles reflected obliquely to the surface of the specimen.

10. Scanning particle mirror microscope as claimed in Claim 1, **characterised by** a contrast diaphragm (14) for selecting out a proportion of the reflected particles, the contrast diaphragm also being constructed as a converter electrode which cooperates with the detector.

## Patentansprüche

1. Rasterteilchenspiegelmikroskop mit
- einer Quelle (1) zum Erzeugen eines Primärteilchenstrahls (2),
- wenigstens einer Linsenanordnung (3) zum Fokussieren des Primärteilchenstrahls,
- einem Rasterablenksystem (4), um den Primärteilchenstrahl über der Probe abzulenken,
- einem Detektor (5) zum Erfassen von Teilchen,
- und Mitteln (7) zum Erzeugen eines Bremsfeldes gerade oberhalb der Probe, wobei das Bremsfeld so angepasst ist, dass wenigstens ein Teil des Primärteilchenstrahls reflektiert wird, bevor er die Probe erreicht, und wenigstens einige der reflektierten Teilchen den Detektor erreichen,
**dadurch gekennzeichnet, dass**
das Rasterablenksystem (4) in der vorderen Brennebene (3a) der Linsenanordnung (3) angeordnet ist.

2. Rasterteilchenspiegelmikroskop nach Anspruch 1, **dadurch gekennzeichnet, dass** die Linsenanordnung durch eine Immersionslinse definiert wird.

3. Rasterteilchenspiegelmikroskop nach Anspruch 1, **dadurch gekennzeichnet, dass** die Linsenanordnung durch eine kombinierte elektrostatisch-magnetische Immersionslinse definiert wird.

4. Rasterteilchenspiegelmikroskop nach Anspruch 1, **dadurch gekennzeichnet, dass** das Rasterablenksystem (4) als ein elektrostatisches Ablenksystem konstruiert ist.

5. Rasterteilchenspiegelmikroskop nach Anspruch 1, **dadurch gekennzeichnet, dass** der Detektor - in der Richtung des Primärteilchenstrahls - in oder vor der Linsenanordnung (3) angeordnet ist.

6. Rasterteilchenspiegelmikroskop nach Anspruch 1, **dadurch gekennzeichnet, dass** die Mittel zum Erzeugen eines Bremsfeldes über der Probe durch die Mittel zum Zuführen einer Bremsspannung auf wenigstens einen Teil der Probe vorgesehen sind.

7. Rasterteilchenspiegelmikroskop nach Anspruch 6, **dadurch gekennzeichnet, dass** der absolute Wert der Bremsspannung größer ist als der absolute Wert der Spannung des Primärteilchenstrahls.

8. Rasterteilchenspiegelmikroskop nach Anspruch 1, **gekennzeichnet durch** eine Kontrastblende (14) zum Ausselektieren eines Anteils der reflektierten Teilchen.

9. Rasterteilchenspiegelmikroskop nach Anspruch 1, **gekennzeichnet durch** eine Kontrastblende (14) zum Ausselektieren eines Anteils der Teilchen, die schräg zur Oberfläche der Probe reflektiert werden.

10. Rasterteilchenspiegelmikroskop nach Anspruch 1, **gekennzeichnet durch** eine Kontrastblende (14) zum Ausselektieren eines Anteils der reflektierten Teilchen, wobei die Kontrastblende auch als eine Konverterelektrode konstruiert ist, die mit dem Detektor zusammenwirkt.

## Revendications

1. Microscope à miroir à particules à balayage avec :
- une source (1) pour générer un faisceau primaire de particules (2),
- au moins un dispositif de lentilles (3) pour focaliser le faisceau de particules primaire,
- un système de déflexion de balayage (4) afin de dévier le faisceau primaire de particules sur l'échantillon,
- un détecteur (5) pour détecter les particules,
- et des moyens (7) pour générer un champ de retard juste au-dessus de l'échantillon, où le champ de retard est adapté en ce qu'au moins une partie du faisceau primaire de particules est réfléchi avant d'atteindre l'échantillon et au moins une partie des particules réfléchies atteignent le détecteur ;
**caractérisé en ce que** le système de déflexion de balayage (4) est disposé dans le plan focal frontal (3a) du dispositif de lentilles (3).

2. Microscope à miroir à particules à balayage selon la revendication 1, **caractérisé en ce que** le dispositif de lentilles est défini par une lentille d'immersion.

3. Microscope à miroir à particules à balayage selon la revendication 1, **caractérisé en ce que** le dispositif de lentilles est défini par une lentille d'immersion électrostatique-magnétique combiné.

4. Microscope à miroir à particules à balayage selon la revendication 1, **caractérisé en ce que** le système de déflexion de balayage (4) est construit comme un système de déflecteur électrostatique.

5. Microscope à miroir à particules à balayage selon la revendication 1, **caractérisé en ce que** le détecteur est disposé, en direction du faisceau primaire de particules, dans ou devant le dispositif de lentille (3).

6. Microscope à miroir à particules à balayage selon la revendication 1, **caractérisé en ce que** les moyens pour générer un champ de retard au-dessus de l'échantillon sont procurés par le moyen pour fournir une tension de retard à au moins une partie de l'échantillon.

7. Microscope à miroir à particules à balayage selon la revendication 6, **caractérisé en ce que** la valeur absolue de la tension de retard est supérieure à la valeur absolue de la tension du faisceau primaire de particules.

8. Microscope à miroir à particules à balayage selon la revendication 1, **caractérisé par** un diaphragme de contraste (14) pour sélectionner une partie des particules réfléchies.

9. Microscope à miroir à particules à balayage selon la revendication 1, **caractérisé par** un diaphragme de contraste (14) pour sélectionner une partie des particules réfléchies, de manière oblique à la surface de l'échantillon.

10. Microscope à miroir à particules à balayage selon la revendication 1, **caractérisé par** un diaphragme de contraste (14) pour sélectionner une partie des particules réfléchies, le diaphragme de contraste (14) étant construit comme une électrode de conversion qui coopère avec le détecteur.
